# EUROPÄISCHE PATENTSCHRIFT

(11) **EP 3 278 431 B1**
(45) Veröffentlichungstag und Bekanntmachung des Hinweises auf die Patenterteilung: **23.10.2019**
(21) Anmeldenummer: 16721068.1
(22) Anmeldetag: 23.03.2016
(51) Int. Cl.: H02K 29/08, H02K 11/215, H01F 1/01, G01R 31/28, H02K 7/00, H02K 7/08

(54) **MAGNETGEBERMITTEL**
MAGNET SENSOR MEANS
MOYEN CODEUR MAGNÉTIQUE

(30) Priorität: 02.04.2015 DE 102015206108
(43) Veröffentlichungstag der Anmeldung: 07.02.2018
(73) Patentinhaber: Bühler Motor GmbH, 90459 Nürnberg (DE)
(72) Erfinder: AHRENS, Matthias, 90455 Nürnberg (DE); BERNREUTHER, Georg, 90449 Nürnberg (DE); RICHTER, Olaf, 90547 Stein (DE); WALL, Andreas, 90453 Nürnberg (DE)
(86) Internationale Anmeldenummer: PCT/DE2016/200157
(87) Internationale Veröffentlichungsnummer: WO 2016/155735

(56) Entgegenhaltungen:
- WO-A1-2015/140961
- DE-A1-102008 040 318
- JP-A- 2013 007 731
- KR-A- 20140 120 870

## Beschreibung

Die Erfindung betrifft ein Magnetgebermittel eines elektrischen Antriebs, welches an einem Wellenende einer Welle oder einem wellenfesten Innenring eines Wälzlagers montiert ist.

Magnetgeber dienen insbesondere zur Erfassung der Lage eines Permanentmagnetrotors eines elektronisch kommutierten Gleichstrommotors (BLDC-Motor). Die Erfassung der Rotorlage ist grundlegende Voraussetzung für eine sensorbezogene Kommutierung des BLDC-Motors. Wesentlich für eine optimale Kommutierung ist ein verdrehsicher befestigter Magnetgeber. Zur Sicherstellung einer Verdrehsicherheit ist es bekannt Magnetgeber formschlüssig mit der Welle zu verbinden. Dies erfordert einen nicht unerheblichen Aufwand für die Herstellung entsprechender Konturen an der Welle.

Zur Befestigung von Magnetgebern an Wellenenden sind diese häufig auch durch Kleben befestigt. Klebeverbindungen eignen sich jedoch nicht bei rauen Umgebungsbedingungen und in Umgebungen mit aggressiven Medien, wie bei Ölpumpenmotoren, welche in der Regel ölgefüllt sind. Klebstoffe enthalten häufig giftige, gesundheitsschädliche Stoffe und sie belasten die Umwelt. Klebeverbindungen sind darüber hinaus in der industriellen Fertigung schwierig zu überwachen und wenig prozesssicher.

Auch Kombinationen aus Formschluss- und Klebeverbindungen sind bekannt, mit entsprechend höherem Herstellungsaufwand.

Unter einem Magnetgeber ist insbesondere ein kleiner Permanentmagnet zu verstehen, welcher aus zumindest zwei Magnetpolen besteht, aber je nach Anwendung auch eine höhere Polpaarzahl aufweisen kann. Häufig ist der Magnetgeber zylinderförmig ausgebildet, wobei eine Hälfte den Nordpol und eine zweite Hälfte den Südpol bildet. Magnetisiert ist dieser Magnetgeber vorzugsweise axial.

Aus der nächstliegenden JP 2013 007731 A ist ein Magnetgebermittel eines elektrischen Antriebs, welches an einem Wellenende einer Welle oder an einem wellenfesten Innenring eines Wälzlagers montiert ist, bekannt, wobei das Magnetgebermittel aus einem Magnetgeber und einem Adapter besteht, der Magnetgeber ein kunststoffgebundener durch Urformen mit dem Adapter verbundener Permanentmagnet ist und dass der Adapter, der aus einem nichtmagnetischen Metall besteht, durch eine kraftschlüssige Verbindung am Wellenende bzw. dem Innenring befestigt ist.

Die DE 10 2008 040 318 A1 offenbart ein Magnetgebermittel eines elektrischen Antriebs, das durch Urformen mit dem Adapter verbunden ist und der Adapter kraftschlüssig am Innenring eines Wälzlagers befestigt ist.

Aus der KR 2014 0120870 A ist ein Magnetgebermittel bekannt, bei dem der Adapter zumindest einen zapfenartigen Vorsprung aufweist, welcher in eine Kavität an einer axialen Endfläche der Welle eingepresst ist und der zapfenartige Vorsprung einen mehrkantigen, insbesondere sechskantigen oder polygonartigen Querschnitt aufweist.

Aufgabe der Erfindung ist es ein Magnetgebermittel darzustellen, bei welcher eine möglichst einfache Verbindung zwischen einem Magnetgeber und einem Wellenende einer Welle oder einem wellenfesten Innenring eines Wälzlagers herstellbar ist, wobei einfache Fertigungs- und Montageverfahren verwendbar sind, welche prozesssicher sind und für welche ein großes Erfahrungswissen existiert. Weiter soll das Magnetgebermittel resistent gegenüber rauen Umgebungsbedingungen, wie chemischer Beständigkeit, Vibrationsfestigkeit und hohen Temperaturschwankungen sein.

Diese Aufgabe wird erfindungsgemäß durch die Merkmale des Anspruchs 1 gelöst. Da das Magnetgebermittel aus einem Magnetgeber und einem Adapter besteht, können die jeweiligen Vorzüge der verwendeten Materialien genutzt werden. Durch Verwendung eines kunststoffgebundenen Magnetgebers lassen sich einfache Verbindungstechniken und gute Gestaltungsmöglichkeiten realisieren. Durch eine kraftschlüssige Befestigung des Adapters am Wellenende bzw. Innenring können einfache erprobte Fügeverfahren eingesetzt werden. Durch die Verwendung von zwei zapfenartigen Vorsprüngen, welche in eine oder zwei Kavitäten an der axialen Endfläche der Welle eingepresst sind, lässt sich eine sichere verdrehsichere Verbindung herstellen. Bei Verwendung einer einzigen Kavität, kann diese in Form einer Längsnut ausgebildet sein.

Weiterbildungen der Erfindung werden in den Unteransprüchen dargestellt.

Besonders bevorzugt ist die Verwendung von Sintermaterial für den Adapter, denn hierdurch besteht eine Vielzahl von Gestaltungsmöglichkeiten welche auf wirtschaftliche Art und Weise einsetzbar sind. Aus Sintermaterialien lassen sich sehr genaue Werkstücke herstellen, daher sind sie sehr gut für kraftschlüssige Verbindungen geeignet. Bei der Wahl des Sintermaterials kann unmagnetisches Material bevorzugt werden, um zu einen hohen Wirkungsgrad des Sensormagnetkreises beizutragen.

Es bestehen mehrere Möglichkeiten den Adapter mit dem Wellenende kraftschlüssig zu verbinden. Bei ausreichend Platzangebot kann ein Abschnitt des Außenumfangs der Welle als Verbindungsfläche genutzt werden. In diesem Fall benötigt der Adapter relativ viel Bauraum, weil aus Festigkeitsgründen auch eine gewisse Mindestmaterialstärke notwendig ist. Bei dieser Lösung bestehen für die Gestaltung des Wellenendes keine besonderen Anforderungen, so dass eine Standardwelle verwendet werden kann. Dies ist aus wirtschaftlichen Gründen interessant.

Eine zweite Möglichkeit besteht darin, den Adapter mit zumindest einem zapfenartigen Vorsprung zu versehen, welcher in eine Kavität an einer axialen Endfläche der Welle eingepresst ist. Hier gewinnt man in der Regel Bauraum, wofür jedoch eine etwas aufwändiger gestaltete Welle erforderlich ist.

Der zapfenartige Vorsprung kann einen mehrkantigen, insbesondere sechskantigen oder polygonartigen Querschnitt aufweisen. Hierdurch lassen sich die Toleranzen für die Pressverbindung wirtschaftlicher gestalten.

Zur Verbindung des Adapters mit dem Magnetgeber ist insbesondere eine Aufnahme vorgesehen. Diese Aufnahme ist vorzugsweise zylindrisch ausgebildet. In solch eine Aufnahme lässt sich das Magnetmaterial unmittelbar einspritzen.

Weiter lässt sich auf einfache Weise ein Formschluss zwischen dem Magnetgeber und dem Adapter herstellen. Diese wird insbesondere dadurch erreicht, indem das Magnetmaterial des Magnetgebers die Aufnahme selbst und eine Ausnehmung in einer Wandung der Aufnahme ausfüllt. Das Magnetmaterial in der Ausnehmung dient dabei als Verdrehsicherung, falls diese exzentrisch angeordnet ist oder keinen runden Querschnitt aufweist. Es ist aber auch möglich zwei oder mehr Ausnehmungen vorzusehen, welche vom Magnetmaterial des Magnetgebers ausgefüllt sind.

Um auch in axialer Richtung für eine formschlüssige Verbindung zu sorgen, ist vorgesehen, dass die Ausnehmung bzw. die Ausnehmungen der Wandung einen sich verändernden Querschnitt aufweist bzw. aufweisen, wobei der Querschnitt in einem von der Aufnahme entfernteren Bereich größer ist als in einem der Aufnahme näheren Bereich.

Alternativ dazu kann das Magnetmaterial des Magnetgebers einen an die Wandung anschließenden und in Bezug auf die Wandung, der Aufnahme gegenüberliegenden Raumbereich einnehmen, welcher einen größeren Querschnitt als die Ausnehmung der Wandung aufweist.

Grundsätzlich lässt sich das Magnetgebermittel sehr gut vorfertigen.

Besonders vorteilhaft ist die Verwendung von Magnetmaterial aus duroplastgebundenen Magnetpartikeln, weil hierdurch die Notwendigkeit eines Formschlusses zum Sinterteil unter Umständen entfallen kann. Duroplastmaterial geht innige Verbindungen mit dem Fügepartner ein, wobei atomare Verbindungen entstehen. In gleicher Weise sind auch thermoplastgebundene Magnetmaterialien verwendbar, wobei hierbei in den meisten Fällen ein zusätzlicher Formschluss erforderlich ist.

Einige Beispiele werden nachfolgend anhand der Zeichnung näher erläutert. Es zeigen:
- Fig. 1a: eine erste Ausführungsform des Magnetgebermittels,
- Fig. 1b: eine dreidimensionale Darstellung einer Welle,
- Fig. 1c: eine dreidimensionale Darstellung eines Adapters,
- Fig. 1d: eine dreidimensionale Darstellung des Adapters aus anderer Perspektive,
- Fig. 1e: eine dreidimensionale Darstellung eines Magnetgebers,
- Fig. 2a: eine zweite Ausführungsform des Magnetgebermittels,
- Fig. 2b: eine zweite Ausführungsform der Welle,
- Fig. 2c: eine zweite Ausführungsform des Adapters gemäß der Erfindung,

- Fig. 2d: eine alternative Darstellung des Adapters aus anderer Perspektive,
- Fig. 2e: eine zweite Ausführungsform des Magnetgebers,
- Fig. 3a: eine dritte Ausführungsform des Magnetgebermittels
- Fig. 3b: eine dritte Ausführungsform der Welle,
- Fig. 3c: eine dritte Ausführungsform des Adapters und
- Fig. 3d: eine dritte Ausführungsform des Magnetgebers.

Hinweis: Bezugszeichen mit Apostroph und entsprechende Bezugszeichen ohne Apostroph bezeichnen namensgleiche Einzelheiten in den Zeichnungen und der Zeichnungsbeschreibung. Es handelt sich dabei um die Verwendung in einer anderen Ausführungsform, dem Stand der Technik und/oder die Einzelheit ist eine Variante. Die Ansprüche, die Beschreibungseinleitung, die Bezugszeichenliste und die Zusammenfassung enthalten gegebenenfalls der Einfachheit halber nur Bezugszeichen ohne Apostroph.

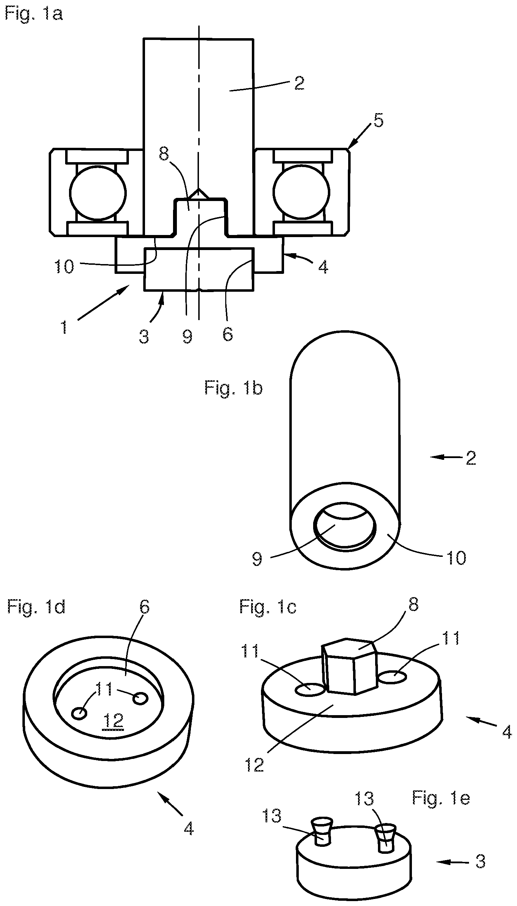

Fig. 1a zeigt eine erste Ausführungsform des Magnetgebermittels 1, welches an einem Wellenende einer Welle 2 montiert ist. Das Magnetgebermittel 1 besteht aus einem Magnetgeber 3 und einem Adapter 4. Weiter ist ein Kugellager 5 dargestellt, mit der die Welle 2 in einem hier nicht gezeigten Antriebsgehäuse gelagert ist. In dieser Ausführungsform ist der Adapter 4 mit einer Aufnahme 6 für den Magnetgeber 3 versehen, welche im Wesentlichen zylindrisch ausgebildet ist. Der Magnetgeber ist im gezeigten Beispiel nur teilweise in der Aufnahme 6 versenkt. Der Adapter 4 umfasst einen zapfenförmigen Vorsprung 8, welcher in eine Kavität 9 am Wellenende der Welle 2 axial eingepresst ist.

Fig. 1b zeigt eine dreidimensionale Darstellung der Welle 2, mit der Kavität 9, welche hier als zylinderförmiges Sackloch ausgeführt ist.

Fig. 1c zeigt den Adapter 4, mit dem Zapfen 8 und einer Wandung 12 in welcher zwei Ausnehmungen 11 mitgeformt sind. Der Zapfen 8 weist einen geringfügig größeren Durchmesser auf als die Kavität 9 der Welle (Fig. 1b). Die Ausnehmungen 11 sind auf der dargestellten Seite der Wandung 12 kegelförmig ausgebildet (nicht zu erkennen).

Fig. 1d ist eine alternative Perspektive des Adapters 4, mit der Aufnahme 6, der Wandung 12 und den Ausnehmungen 11. Der Durchmesser der Ausnehmungen ist hier geringer als der Durchmesser auf der gegenüberliegenden Seite der Wandung (siehe Fig. 1c).

Fig. 1e ist eine dreidimensionale Darstellung des Magnetgebers 3, welcher zwei Vorsprünge (13) aufweist, die sich in achsparalleler Richtung aus dem Magnetgeber 3 erstrecken. Im Magnetgebernahen Bereich sind die Vorsprünge zylindrisch und am Ende sind die Vorsprünge kegelig erweitert. Der Magnetgeber 3, wie es hier dargestellt ist, existiert nicht als Einzelteil, sondern wird mit dem Adapter durch Urformen gefügt.

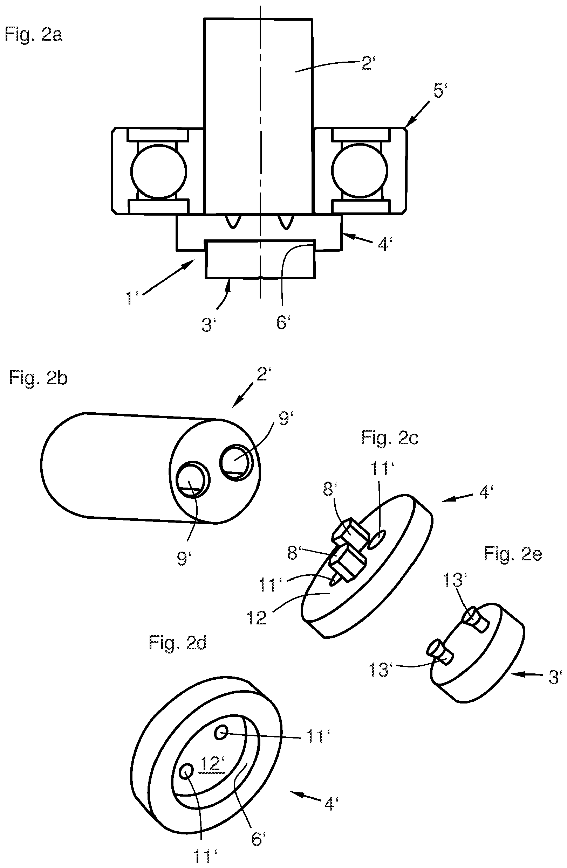

Fig. 2a zeigt eine zweite Ausführungsform des Magnetgebermittels 1', mit einem Magnetgeber 3', einem Adapter 4', einem Lager 5' und einer Welle 2'. Der Magnetgeber 3' ist in eine Aufnahme 6' des Adapters aufgenommen und formschlüssig mit diesem Verbunden (hier nicht zu erkennen).

Fig. 2b zeigt eine zweite Ausführungsform der Welle 2', welche zwei Kavitäten 9' aufweist, welche sich parallel zueinander und zur Längsachse der Welle 2' in der Welle 2' erstrecken.

Fig. 2c zeigt eine zweite, erfindungsgemäße Ausführungsform des Adapters 4', mit zwei zapfenartigen Vorsprüngen 8' und zwei Ausnehmungen 11', welche kegelförmig erweitert sind und Durchbrüche durch eine Wandung 12' sind. Die Länge der Vorsprünge 8' ist geringfügig kleiner als die Tiefe der Kavitäten 9' der Welle 2' (Fig. 2b).

In Fig. 2d ist der Adapter 4' alternativ aus anderer Perspektive dargestellt, mit einer Aufnahme 6' für den Magnetgeber der Wandung 12' und den Ausnehmungen 11', welche hier einen geringeren Querschnitt aufweisen als auf der gegenüberliegenden Seite der Wandung (Fig. 2c).

Fig. 2e eine zweite Ausführungsform des Magnetgebers 3', welcher in seiner Grundform zylinderförmig ausgebildet ist und zwei Vorsprünge 13' aufweist, welche im magnetgebernahen Bereich zylindrisch und im davon entfernten Bereich kegelförmig erweitert sind.

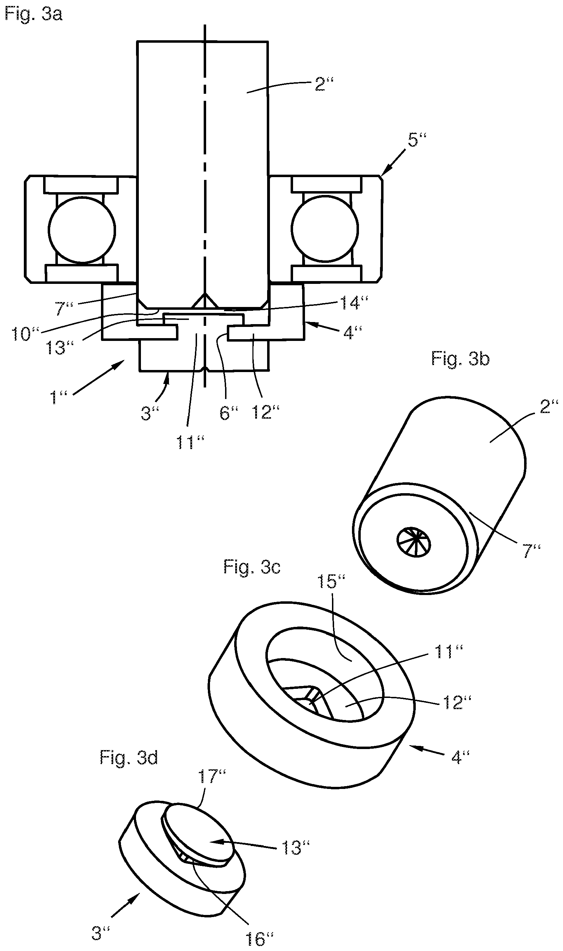

Fig. 3a zeigt eine dritte Ausführungsform des Magnetgebermittels 1", mit einer Welle 2", einem Adapter 4", einem Magnetgeber 3" und einem Kugellager 5". Der Adapter ist hier auf einem Abschnitt eines Außenumfangsbereichs 7" der Welle 2" aufgepresst und ist in seiner Grundform topfförmig ausgebildet, wobei im Topfboden eine Ausnehmung 11" vorhanden ist, welche auch eine Aufnahme 6" für den Magnetgeber bildet. Der größte Teil des Magnetgebers 3" liegt jedoch frei. Von diesem freiliegenden Bereich des Magnetgebers 3" erstreckt sich axial ein Vorsprung 13", welcher an seinem Ende eine Erweiterung aufweist um einen Formschluss mit einer Wandung 12" des Adapters 4" einzugehen. Zwischen einer Endfläche 10" der Welle und dem Magnetgeber 3" ist ein Abstand 14" vorgesehen, welcher den Wirkungsgrad des Sensormagnetkreises verbessert.

Fig. 3b zeigt eine dritte Ausführungsform der Welle 2" welche keine besonderen Aufnahmegeometrien für den Adapter aufweist, welcher lediglich an dem Außenumfangsbereich 7" aufgepresst ist.

Fig. 3c zeigt eine dritte Ausführungsform des Adapters 4", mit der Ausnehmung 11", welche im Wesentlichen quadratischen ausgebildet ist, um als Verdrehsicherung zu wirken. Der Adapter ist in seiner Grundform topfförmig ausgebildet. Die radiale Innenumfangsfläche 15" des Topfes wirkt mit der Außenumfangsfläche 7" (Fig. 3a und 3b) zusammen. Der Topfboden bildet die Wandung 12".

Fig. 3d stellt eine dritte Ausführungsform des Magnetgebers 3" dar, mit dem Vorsprung 13", welcher aus einem im Wesentlichen quadratischen Bereich 16" und einem zylindrisch erweiterten Bereich 17" besteht. Der quadratische Bereich 16" korrespondiert mit der quadratischen Ausnehmung 11" und bildet damit eine Verdrehsicherung des Magnetgebers 3" gegenüber dem Adapter 4". Der zylindrisch erweiterte Bereich 17" bildet mit der Wandung 12" (Fig. 3a und 3c) einen Formschluss in Axialrichtung.

### Bezugszeichenliste

- 1: Magnetgebermittel
- 2: Welle
- 3: Magnetgeber
- 4: Adapter
- 5: Kugellager
- 6: Aufnahme
- 7: Außenumfangsbereich
- 8: Vorsprung
- 9: Kavität
- 10: Endfläche
- 11: Ausnehmung
- 12: Wandung
- 13: Vorsprung
- 14: Abstand
- 15: Innenumfangsfläche
- 16: quadratischer Bereich
- 17: zylindrischer Bereich

## Patentansprüche

1. Magnetgebermittel (1) eines elektrischen Antriebs, welches an einem Wellenende einer Welle (2) oder an einem wellenfesten Innenring eines Wälzlagers montiert ist, wobei das Magnetgebermittel (1) aus einem Magnetgeber (3) und einem Adapter (4) besteht, wobei der Magnetgeber (3) ein kunststoffgebundener durch Urformen mit dem Adapter (4) verbundener Permanentmagnet ist und wobei der Adapter (4) durch eine kraftschlüssige Verbindung an dem Wellenende bzw. dem Innenring befestigt ist, **dadurch gekennzeichnet, dass** der Adapter (4) zwei zapfenartige Vorsprünge (8') aufweist, welche in eine oder zwei Kavitäten (9) an der axialen Endfläche der Welle eingepresst sind.

2. Magnetgebermittel (1) nach Anspruch 1, **dadurch gekennzeichnet, dass** der Adapter (4) aus einem Sintermaterial besteht, insbesondere einem unmagnetischen Sintermaterial.

3. Magnetgebermittel (1) nach Anspruch 1 oder 2, **dadurch gekennzeichnet, dass** der Adapter (4) an einem Außenumfangbereich (7) der Welle (2) oder an einem Innenumfangsbereich des Innenrings mit dieser/diesem verbunden ist.

4. Magnetgebermittel (1) nach zumindest einem der vorangehenden Ansprüche, **dadurch gekennzeichnet, dass** die zapfenartigen Vorsprünge (8') einen mehrkantigen, insbesondere sechskantigen oder polygonartigen Querschnitt aufweisen.

5. Magnetgebermittel (1) nach zumindest einem der vorangehenden Ansprüche, **dadurch gekennzeichnet, dass** der Adapter (4) eine Aufnahme (6) für den Magnetgeber (3) aufweist.

6. Magnetgebermittel (1) nach Anspruch 5, **dadurch gekennzeichnet, dass** der Magnetgeber (3) und der Adapter (4) eine formschlüssige Verbindung miteinander eingehen.

7. Magnetgebermittel (1) nach Anspruch 5 und 6, **dadurch gekennzeichnet, dass** der das Magnetmaterial des Magnetgebers (3) die Aufnahme (6) selbst und eine Ausnehmung (11) in einer Wandung (12) der Aufnahme (6) ausfüllt.

8. Magnetgebermittel (1) nach Anspruch 7, **dadurch gekennzeichnet, dass** die Wandung (12) zwei Ausnehmungen (11) aufweist, welche vom Magnetmaterial des Magnetgebers (3) ausgefüllt sind.

9. Magnetgebermittel (1) nach Anspruch 7 oder 8, **dadurch gekennzeichnet, dass** die Ausnehmung bzw. die Ausnehmungen (11) der Wandung (12) einen sich verändernden Querschnitt aufweist bzw. aufweisen, wobei der Querschnitt in einem von der Aufnahme (6) entfernteren Bereich größer ist als in einem der Aufnahme (6) näheren Bereich.

10. Magnetgebermittel (1) nach Anspruch 7, **dadurch gekennzeichnet, dass** das Magnetmaterial des Magnetgebers (3) einen an die Wandung (12) anschließenden und in Bezug auf die Wandung (12), der Aufnahme (6) gegenüberliegenden Raumbereich einnimmt, welcher einen größeren Querschnitt als die Ausnehmung (11) der Wandung (12) aufweist.

11. Magnetgebermittel (1) nach zumindest einem der vorangehenden Ansprüche, **dadurch gekennzeichnet, dass** das Magnetmaterial aus duroplastgebundenen Magnetpartikeln besteht.

## Claims

1. Magnet sensor means (1) of an electrical drive, said means being mounted on a shaft end of a shaft (2) or on a rolling-contact bearing inner ring secured to the shaft, the magnet sensor means (1) consisting of a magnet sensor (3) and an adapter (4), the magnet sensor (3) being a plastic-bonded permanent magnet connected to the adapter (4) by primary shaping processes and the adapter (4) being fastened to the shaft end or inner ring by means of a frictional connection, **characterised in that** the adapter (4) has two pin-like projections (8') that are pressed into one or two cavities (9) in the axial end face of the shaft.

2. Magnet sensor means (1) according to claim 1, **characterised in that** the adapter (4) consists of a sintering material, in particular a non-magnetic sintering material.

3. Magnet sensor means (1) according to either claim 1 or claim 2, **characterised in that** the adapter (4) is connected to the shaft (2) on an outer circumferential region (7) thereof or to the inner ring on an inner circumferential region thereof.

4. Magnet sensor means (1) according to at least one of the preceding claims, **characterised in that** the pin-like projections (8') have a polygonal, in particular hexagonal or polygon-like, cross section.

5. Magnet sensor means (1) according to at least one of the preceding claims, **characterised in that** the adapter (4) has a receptacle (6) for the magnet sensor (3).

6. Magnet sensor means according to claim 5, **characterised in that** the magnet sensor (3) and the adapter (4) establish an interlocking connection with one another.

7. Magnet sensor means (1) according to claims 5 and 6, **characterised in that** the magnet material of the magnet sensor (3) fills the receptacle (6) itself and a recess (11) in a wall (12) of the receptacle (6).

8. Magnet sensor means (1) according to claim 7, **characterised in that** the wall (12) has two recesses (11) that are filled by the magnet material of the magnet sensor (3).

9. Magnet sensor means (1) according to either claim 7 or claim 8, **characterised in that** the recess or recesses (11) in the wall (12) has/have a varying cross section, the cross section being larger in a region further from the receptacle (6) than in a region closer to the receptacle (6).

10. Magnet sensor means (1) according to claim 7, **characterised in that** the magnet material of the magnet sensor (3) occupies a spatial region adjacent to the wall (12), opposite the receptacle (6) in relation to the wall (12) and having a greater cross section than the recess (11) in the wall (12).

11. Magnet sensor means (1) according to at least one of the preceding claims, **characterised in that** the magnet material consists of thermosetting plastic-bonded magnetic particles.

## Revendications

1. Moyen de codeur magnétique (1) d'un entrainement électrique, qui est monté à une extrémité d'arbre d'un arbre (2) ou à une bague intérieure d'un palier à roulement fixe avec l'arbre, le moyen de codeur magnétique (1) étant constitué d'un codeur magnétique (3) et d'un adaptateur (4), le codeur magnétique (3) étant un aimant permanent à liant synthétique relié à l'adaptateur (4) par moulage initial, et l'adaptateur (4) étant fixé par une liaison par adhérence à l'extrémité d'arbre ou respectivement à ladite bague intérieure,
**caractérisé en ce que** l'adaptateur (4) présente deux protubérances (8') en forme de tenon, qui sont montées à force dans une ou deux cavités (9) sur la surface terminale axiale de l'arbre.

2. Moyen de codeur magnétique (1) selon la revendication 1, **caractérisé en ce que** l'adaptateur (4) est réalisé en un matériau fritté, notamment un matériau fritté non magnétique.

3. Moyen de codeur magnétique (1) selon la revendication 1 ou la revendication 2, **caractérisé en ce que** l'adaptateur (4) est relié à l'arbre ou à ladite bague intérieure respectivement au niveau d'une zone de périphérie extérieure (7) de l'arbre (2) ou d'une zone de périphérie intérieure de ladite bague intérieure.

4. Moyen de codeur magnétique (1) selon l'une au moins des revendications précédentes, **caractérisé en ce que** les protubérances (8') en forme de tenon, présentent une section transversale à côtés multiples, notamment une section hexagonale ou polygonale.

5. Moyen de codeur magnétique (1) selon l'une au moins des revendications précédentes, **caractérisé en ce que** l'adaptateur (4) comporte un logement d'accueil (6) pour le codeur magnétique (3).

6. Moyen de codeur magnétique (1) selon la revendication 5, **caractérisé en ce que** le codeur magnétique (3) et l'adaptateur (4) réalisent une liaison réciproque par complémentarité de formes.

7. Moyen de codeur magnétique (1) selon la revendication 5 et la revendication 6, **caractérisé en ce que** le matériau magnétique du codeur magnétique (3) remplit le logement d'accueil (6) lui-même et un évidement (11) dans une paroi (12) du logement d'accueil (6).

8. Moyen de codeur magnétique (1) selon la revendication 7, **caractérisé en ce que** la paroi (12) comporte deux évidements (11), qui sont remplis par le matériau magnétique du codeur magnétique (3).

9. Moyen de codeur magnétique (1) selon la revendication 7 ou la revendication 8, **caractérisé en ce que** l'évidement ou les évidements (11) de la paroi (12) présente ou présentent une section transversale, qui varie, la section transversale étant plus grande dans une zone plus éloignée du logement d'accueil (6) que dans une zone plus proche du logement d'accueil (6).

10. Moyen de codeur magnétique (1) selon la revendication 7, **caractérisé en ce que** le matériau magnétique du codeur magnétique (3) occupe une zone spatiale se raccordant à la paroi (12) et opposée au logement d'accueil (6) en se référant à la paroi (12), qui présente une section transversale plus grande que l'évidement (11) de la paroi (12) .

11. Moyen de codeur magnétique (1) selon l'une au moins des revendications précédentes, **caractérisé en ce que** le matériau magnétique est constitué de particules magnétiques liées par une résine thermodurcissable.
